# EUROPÄISCHE PATENTSCHRIFT

(11) **EP 2 274 188 B1**
(45) Veröffentlichungstag und Bekanntmachung des Hinweises auf die Patenterteilung: **11.04.2012**
(21) Anmeldenummer: 09733384.3
(22) Anmeldetag: 15.04.2009
(51) Int. Cl.: G01R 31/28, H05K 1/02

(54) **SCHUTZANORDNUNG ZUM SCHUTZ SICHERHEITSRELEVANTER ELEKTRONIKSCHALTUNGEN VOR FEHLFUNKTIONEN**
PROTECTIVE ARRANGEMENT FOR THE PROTECTION OF SAFETY-RELEVANT ELECTRONIC CIRCUITS FROM MALFUNCTION
ARRANGEMENT DE PROTECTION POUR PROTEGER DES CIRCUITS ELECTRONIQUES IMPORTANTS POUR LA SECURITE CONTRE DES DEFAUTS DE FONCTIONNEMENT

(30) Priorität: 18.04.2008 DE 102008019673
(43) Veröffentlichungstag der Anmeldung: 19.01.2011
(73) Patentinhaber: Lucas Automotive GmbH, 56070 Koblenz (DE)
(72) Erfinder: FUCHS, Matthias, 42551 Velbert (DE); JUNGLAS, Marco, 56073 Koblenz (DE); MUDERS, Lutz, 55413 Oberheimbach (DE); OHLIG, Benedikt, 56179 Vallendar (DE)
(74) Vertreter: Schmidt, Steffen
(86) Internationale Anmeldenummer: PCT/EP2009/002765
(87) Internationale Veröffentlichungsnummer: WO 2009/127409

(56) Entgegenhaltungen:
- EP-B- 1 574 869
- DE-A1- 19 838 886
- DE-A1- 19 854 914
- US-B1- 6 325 466

## Beschreibung

### Hintergrund

Nachstehend wird eine Schutzanordnung zum Schutz sicherheitsrelevanter Elektronikschaltungen vor Fehlfunktionen beschrieben. Sie basiert auf dem Prinzip der Selbstüberwachung und ermöglicht eine permanente Überwachung wichtiger Betriebsparameter, wie z.B. Spannung in der Elektronikschaltung, und somit das frühzeitige Erkennen drohender Defekte.

Durch Schutzelemente zum rechtzeitigen Erkennen von Kurzschlüssen zwischen Leiterbahnen auf einer Leiterplatte werden kritische Auswirkungen solcher Kurzschlüsse verhindert, wobei die Schutzelemente direkt auf der Leiterplatte zu realisieren sind.

Kurzschlüsse, beispielsweise durch in ein Gehäuse der Elektronikschaltung eindringende Feuchtigkeit, führen zu einer unbeabsichtigten Aktivierung eines elektrisch anzusteuernden Bauteils. Dieses Problem tritt angesichts der zunehmenden Elektronifizierung von Kraftfahrzeugen häufiger in den Vordergrund. Hier sei als ein Beispiel auf elektronische Parkbremsen verwiesen, bei denen im bzw. beim Aktor die zugehörige Steuerelektronik angeordnet ist.

### Stand der Technik

In vielen elektronischen Geräten kommen Leiterplatten bzw. Multilagenplatinen, die mehrere geschichtete Leiterplatten umfassen, zum Einsatz. Eine Leiterplatte ist ein Träger aus isolierendem Material mit festhaftenden leitenden Verbindungen. Sie dient der mechanischen Befestigung und der elektrischen Verbindung elektronischer Schaltungs(bau)teile. Auf oder in der Leiterplatte können direkt integrierte Schaltkreise platziert sein. In einer Multilagenplatine sind solche Leiterplatten elektrisch und/oder mechanisch miteinander verbunden.

Durch Kurzschlüsse auf solchen Leiterplatten bzw. in einer Multilagenplatine kann es zu Fehlfunktionen kommen.

Spannungsgesteuerte Bauteile zeigen sich sehr empfindlich gegen Kurzschlüsse mit einem entsprechenden Betriebspotential. Kommt es beispielsweise in einer Schaltung zur Ansteuerung einer elektronischen Parkbremse (EPB) in einem Landfahrzeug zu einem Kurzschluss mit einem Betriebspotential, welches dem der EPB entspricht, so wird die EPB unbeabsichtigt betätigt, was im Falle eines Lösens im Parkbetrieb und im Falle eines Zuspannens im Fahrbetrieb besonders sicherheitskritisch ist.

Um einen Kurzschluss auf einer Leiterplatte festzustellen, ist es bekannt, auf der Leiterplatte aktive Schutzbeschaltungen für Bereiche mit Versorgungsspannungspotential anzubringen. Eine aktive Schutzbeschaltung umfasst eine Auswertelektronik, durch die Parameter, wie beispielsweise Spannung, Stromstärke und Temperatur, überwacht werden. Auf der Leiterplatte angeordnete Schaltungs(bau)teile und - gruppen werden dann abhängig von den Messungen der Auswertelektronik in einen sicheren Zustand überführt. Dies kann eine Fehlfunktion bzw. eine unbeabsichtigte Ansteuerung oder Beschädigung nachgeschalteter Bauteile durch einen Kurzschlussstrom, der meist nennenswert über dem Betriebsstrom liegt, verhindern.

Die DE 198 54 914 A1 beschreibt ein Verfahren und eine Schaltungsanordnung zum Erkennen eines Fehlers, insbesondere eines Kurzschlusses, im Lastkreis eines Leistungsschalters. Als Maß für einen Kurzschluss wird der Beginn der Regelung einer im Leistungsschalter umfassten Laststrombegrenzung herangezogen.

Kommt es jedoch zu mehreren, parallelen Kurzschlüssen, so ist durch die dort beschriebenen Sicherungsmöglichkeiten kein ausreichender Schutz gewährt.

### Aufgabe

Ausgehend von diesem Problem soll eine Schutzanordnung angegeben werden, die einfach und kostengünstig zu realisieren ist.

### Lösung

Als Lösung dieser Aufgabe dient die in Patentanspruch 1 angegebene Schutzschaltung.

Die Auswerteelektronik kann als eine diskrete Erkennungsschaltung, aber auch als ein Mikroprozessor oder eine anwendungsspezifische integrierte Schaltung (ASIC) gefertigt sein.

Die erste Leiterschleife mit der zugehörigen Auswerteelektronik dient der Erkennung von potentiellen Kurzschlüssen zwischen der Versorgungsspannungsleiterbahn und anderen Leiterbahnen auf der Leiterplatte, wie sie zum Beispiel durch Flüssigkeiten oder Fremdkörper entstehen.

Die erste Leiterschleife hat ein vorgegebenes Spannungspotential, das nicht über dem Versorgungsspannungspotential liegt, oder Massepotential.

Ein Kurzschlusspotential liegt nennenswert über dem Versorgungsspannungspotential. Hat eine Verbindungsleitung, die von der ersten Leiterschleife umschlossen ist, Kurzschlusspotendal, so überträgt sich dieses auch auf die erste Leiterschleife. Die Auswerteelektronik misst die nennenswerte Potentialerhöhung auf der ersten Leiterschleife und erkennt somit den Kurzschluss.

Wird eine Fehlspannung oder ein Fehlstrom erkannt, der ein Indikator für einen oder mehrere Kurzschlüsse ist, kann eine entsprechende Fehlermeldung an den Anwender erfolgen und die Schaltung auf der Leiterplatte kann in einen sicheren Zustand gebracht werden. Die von der ersten Leiterschleife umschlossene Schaltung kann z.B. dauerhaft deaktiviert werden.

Hierzu dienen verschiedene, auch miteinander kombinierbare Maßnahmen.

In einem sicherheitskritischen Leitungspfad der Leiterplatte kann ein Sicherungselement und/oder eine Leiterbahnverjüngung vorgesehen sein. Dadurch ist im Kurzschlussfall die Abgrenzung von Bereichen der Leiterplatte sichergestellt, die Kurzschlusspotential haben.

Halbleiterschaltkreise, wie ein Prozessor oder eine anwendungsspezifische, integrierte Schaltung (ASIC), die auf der Leiterplatte angeordnet sein können, haben eine integrierte Halbleiterstruktur, die im Kurzschlussfall kontrolliert zerstört wird. Auch dadurch ist im Kurzschlussfall die Abgrenzung von Bereichen der Leiterplatte sichergestellt, die Kurzschlusspotential haben.

In einem Prozessor, der von der Leiterplatte umfasst sein kann, wird im Kurzschlussfall eine in dem Prozessor umfasste Flashzelle beschrieben. Dies hat ebenso eine Deaktivierung der von dem Kurzschluss betroffenen Schaltungs(bau)teile bzw. - gruppen zur Folge.

Die beanspruchte Schutzschaltung umfasst eine zweite Leiterschleife, die auf der Leiterplatte so angeordnet ist, dass sie die elektrisch leitende Verbindung zwischen dem ersten Anschluss des Ansteuerbausteins und dem ersten Anschluss des Halbleiterschalters von dem Halbleiterschalter, der Versorgungsspannungsleiterbahn und zumindest von Bereichen des Ansteuerbausteins abschirmt, die auch mit der Versorgungsspannungsleiterbahn in Verbindung stehen.

Diese zweite Leiterschleife wird von keiner Auswerteelektronik überwacht.

Die zweite Leiterschleife liegt auf einem vorgegebenen Potential. Dieses ist derart gewählt, dass es bei einem oder mehreren Kurzschlüssen mit der umschlossenen Schaltung zu einem unkritischen Zustand führt. Die zweite Leiterschleife kann potentialfrei sein.

Der erste Anschluss des Halbleiterschalters ist von der zweiten Leiterschleife vollständig umschlossen. Dadurch ist sichergestellt, dass bei einem oder mehreren Kurzschlüssen mit der von der zweiten Leiterschleife umgebenen Schaltung das am ersten Anschluss des Halbleiterschalters anliegende hohe Kurzschlusspotential durch die zweite Leiterschleife definiert gesenkt wird. Dies erfolgt dadurch, dass die zweite Leiterschleife so widerstandsbehaftet ist, dass sie ab einem definierten Grenzwert am ersten Anschluss des Halbleiterschalters diesem Strom entzieht und somit das am Halbleiterschalter anliegende Potential definiert herabsetzt.

Dies ermöglicht eine passive Absicherung gegen einen Durchbruch in der Ansteuerung des Halbleiterschalters. Somit kann eine unbeabsichtigte Ansteuerung eines dem Halbleiterschalter nachgeschalteten Bauteils verhindert werden. Bei dem nachgeschalteten Bauteil kann es sich beispielsweise um eine elektronische Parkbremse in einem Landfahrzeug handeln.

Ein definiertes Betriebspotential des nachgeschalteten Bauteils liegt nennenswert unterhalb des Kurzschlusspotentials. Daher lassen die beiden Leiterschleifen die Ansteuerung des nachgeschalteten Bauteils zu und lassen das Ansteuerpotential nicht gezielt abfallen bzw. melden keinen Kurzschluss.

Solche Leiterschleifen sind bevorzugt um Bereiche mit Versorgungsspannungspotential und/oder um kritische Schaltungs(bau)teile bzw. -gruppen angeordnet.

Der Halbleiterschalter und der Ansteuerbaustein haben jeweils einen zweiten Anschluss. Der zweite Anschluss des Halbleiterschalters sowie der zweite Anschluss des Ansteuerbausteins sind elektrisch leitend mit der Versorgungsspannungsleiterbahn verbunden. Die erste Leiterschleife umschließt die elektrisch leitenden Verbindungen zwischen der Versorgungsspannungsleiterbahn und dem Halbleiterschalter bzw. dem Ansteuerbaustein. Hierbei ist der zweite Anschluss des Ansteuerbausteins so an dem Ansteuerbaustein angeordnet, dass sein Abstand zu der Versorgungsspannungsleiterbahn möglichst gering ist.

Weiterhin hat der Ansteuerbaustein einen dritten und einen vierten Anschluss. Der dritte sowie der vierte Anschluss des Ansteuerbausteins haben ein Massepotential.

Der erste Anschluss des Ansteuerbausteins ist zwischen dem dritten und dem vierten Anschluss des Ansteuerbausteins angeordnet.

Ein Anfang der zweiten Leiterschleife ist mit dem dritten Anschluss des Ansteuerbausteins elektrisch leitend verbunden. Ein Ende der zweiten Leiterschleife ist mit dem vierten Anschluss des Ansteuerbausteins elektrisch leitend verbunden.

Durch diese Anordnung der zweiten Leiterschleife ist sie als geschlossene, zweite Leiterschleife angeordnet. Sie schirmt die elektrisch leitende Verbindung zwischen dem ersten Anschluss des Ansteuerbausteins und dem ersten Anschluss des Halbleiterschalters von dem Halbleiterschalter und zumindest von den Bereichen des Ansteuerbausteins ab, die mit der Versorgungsspannungsleiterbahn in Verbindung stehen.

Zudem ist die Schwellenspannung des mindestens einen Halbleiterschalters ausreichend hoch gewählt, dass die in einem Kurzschlussfall zwischen zwei Zuleitungen des Halbleiterschalters an einem nachgeschalteten Bauteil anliegende Spannung nicht ausreicht, um das Bauteil zu betreiben und/oder zu beschädigen.

Zusätzlich ist es auch von Vorteil, den Betriebsspannungsbereich eines nachgeschalteten Bauteils möglichst eng zu tolerieren.

Außerdem ist es vorteilhaft, wenn die erste und die zweite Leiterschleife zumindest abschnittsweise frei liegen und nicht mit Lötstoplack oder einer anderen Isolation abgedeckt sind.

In einer speziellen Ausführungsform ist der Halbleiterschalter ein Transistor und der erste Anschluss des Halbleiterschalters ein Gateanschluss.

Bei dieser Ausführungsform ist mindestens eine Diode in der elektrischen Verbindung zwischen dem ersten Anschluss des Ansteuerbausteins und dem Gateanschluss des Transistors angeordnet und/oder mindestens ein Spannungsteiler im Transistor vorgesehen. Hiermit erfolgt eine Erhöhung der Schwellenspannung des Transistors auf ein ausreichendes Maß und damit werden die Auswirkungen von Kurzschlüssen herabgesetzt.

Die mindestens eine Diode sowie der mindestens eine Spannungsteiler können im Transistor integriert sein, um den Einfluss äußerer Störungen gering zu halten.

Je höher die Schwellenspannung des Transistors gewählt wird, desto niedriger ist die im Kurzschlussfall an einem nachgeschalteten Motor anliegende Spannung. Diese am Motor anliegende Spannung ist niedriger als die Betriebsspannung des Motors.

Der Transistor hat einen dritten Anschluss, der ein Sourceanschluss ist.

Bei der beschriebenen Ausführungsform sind der Gateanschluss des Transistors und der erste Anschluss des Ansteuerbausteins elektrisch leitend verbunden. Zudem ist der Sourceanschluss des Transistors elektrisch leitend mit dieser elektrisch leitenden Verbindung verbunden.

Hierbei kann die elektrisch leitende Verbindung zwischen dem Sourceanschluss des Transistors und der elektrisch leitenden Verbindung zwischen dem Gateanschluss des Transistors und dem ersten Anschluss des Ansteuerbausteins mindestens einen Ableitwiderstand umfassen.

Durch die Einführung eines Ableitwiderstandes oder einer Stromquelle zu einem unkritischen Potential, die ebenfalls in der elektrisch leitenden Verbindung umfasst sein kann, erfolgt eine Umwandlung einer leistungslosen Spannungsansteuerung in eine leistungsgetriebene Ansteuerung.

Ebenso kann die elektrisch leitende Verbindung zwischen dem Gateanschluss des Transistors und dem ersten Anschluss des Ansteuerbausteins mindestens einen Ableitwiderstand umfassen.

In einer alternativen Ausführungsform sind auf der Leiterplatte mindestens zwei Transistoren umfasst. Zwischen zwei elektrisch leitenden Verbindungen, die jeweils zwischen einem Gateanschluss eines Transistors und einem Anschluss des Ansteuerbausteins gebildet sind, ist eine elektrisch leitende Kopplung vorgesehen. Diese elektrisch leitende Kopplung umfasst mindestens einen Kopplungswiderstand.

Durch die mindestens eine elektrisch leitende Kopplung ist sichergestellt, dass bei einer fehlerhaften Ansteuerung eines der mindestens zwei Transistoren automatisch auch der andere Transistor angesteuert wird. Dies verringert die Spannungsdifferenz in der Schaltung, die ein Maß für die kritische Auswirkung von Kurzschlüssen ist.

Der Kopplungswiderstand ist so gewählt, dass durch die Kopplung nur Strom fließt, wenn die anliegende Spannung nennenswert über der Betriebsspannung liegt. Im fehlerfreien Fall wird daher nur der Transistor angesteuert, bei dem die Ansteuerung auch beabsichtigt ist. Nur im Kurzschlussfall werden beide Transistoren angesteuert.

Die zweite Leitungsschleife umgibt bei dieser alternativen Ausführungsform die elektrisch leitenden Verbindungen vollständig, die jeweils zwischen einem Gateanschluss eines Transistors und einem Anschluss des Ansteuerbausteins ausgebildet sind. Hierbei umschließt sie die beiden Gateanschlüsse.

Funktion und Wirkung der zweiten Leiterschleife sind in diesem Ausführungsbeispiel analog zu der Funktion und der Wirkung der zweiten Leiterschleife für nur einen umschlossenen Gateanschluss.

Des Weiteren wird eine passive Schutzfläche zwischen zwei Leiterplatten einer Multilagenplatine definiert, wobei die Multilagenplatine mindestens zwei Leiterplatten umfasst. Auf jeder der umfassten Leiterplatten ist eine zuvor beschriebene Schutzschaltung angeordnet. Zudem sind auf jeder der Leiterplatten Schaltungs(bau)teile bzw. -gruppen angeordnet; beispielsweise die die bereits für die eingangs beschriebene Leiterplatte angeführt sind.

Eine erste der mindestens zwei Leiterplatten ist über einer zweiten Leiterplatte angeordnet und die erste und die zweite Leiterplatte sind mechanisch und/oder elektrisch miteinander verbunden.

Die passive Schutzfläche umfasst eine Leiterfläche, die zwischen der ersten und der zweiten Leiterplatte angeordnet ist. Diese Leiterfläche umschließt die elektrisch leitenden Verbindungen zwischen der ersten und der zweiten Leiterplatte.

Die Leiterfläche liegt auf einem vorgegebenen Potential. Die Leiterfläche kann Massepotential haben.

Diese Leiterfläche wird von keiner Auswerteelektronik überwacht.

Die Leiterfläche ist so angeordnet, dass zwei in der Multilagenplatine umfasste Leiterplatten im Kurzschlussfall auf einer der in der Multilagenplatine umfassten Leiterplatten in einen unkritischen Zustand überführt werden.

Bei einem oder mehreren Kurzschlüssen auf einer der zwei Leiterplatten schirmt die Leiterfläche die beiden Leiterplatten praktisch vollständig gegeneinander ab, so dass das hohe Kurzschlusspotential auf der fehlerhaften Leiterplatte nicht auf die fehlerfreie Leiterplatte durchschlägt, sondern durch die Leiterfläche definiert gesenkt wird. Dies erfolgt dadurch, dass die Leiterfläche so widerstandsbehaftet ist, dass sie ab einem definierten Grenzpotential einer Verbindung zwischen der ersten und der zweiten Leiterplatte Strom entzieht. Somit setzt sie das Kurzschlusspotential dieser Verbindung definiert herab.

Dies ermöglicht eine passive Absicherung gegen einen Durchbruch des Kurzschlusspotentials der fehlerhaften Leiterplatte auf die fehlerfreie Leiterplatte.

Zudem wird ein elektronisches System zum Betreiben einer elektromechanischen Feststell-Bremsanlage eines Fahrzeugs definiert, das mindestens eine zuvor beschriebene Schutzschaltung umfasst.

Das elektronische System kann wenigstens eine Eingabeeinheit zum Erfassen eines Fahrerwunsches aufweisen. Dieser Fahrerwunsch kann von einer Steuereinheit ausgewertet werden. Die Steuereinheit kann wenigstens eine Stelleinheit zum Betätigen wenigstens einer Bremse ansteuern. Diese Stelleinheit kann wenigstens zwei Steuerkomponenten umfassen. Eine erste Steuerkomponente kann der Eingabeeinheit zugeordnet sein und wenigstens eine zweite Steuerkomponente kann der wenigstens einen Stelleinheit zugeordnet sein.

Die erste Steuerkomponente und die wenigstens eine zweite Steuerkomponente können in einem Master-Slave-Verhältnis zueinander stehen und die wenigstens eine zweite Steuerkomponente, die der wenigstens einen Stelleinheit zugeordnet ist, kann zum Ansteuern der Stelleinheit erforderliche Leistungsschalter, wie z.B. Transistoren, umfassen.

Die erste Steuerkomponente, die der Eingabeeinheit zugeordnet ist, kann den Fahrerwunsch auswerten und die entsprechende Ansteuerung (z.B. Zuspannen oder Lösen) der wenigstens einen Stelleinheit festlegen. Sie kann örtlich im Bereich der Eingabeeinheit vorgesehen sein.

Die Steuerkomponenten können über wenigstens ein Bussystem miteinander kommunizieren. Sie können ebenso über ein redundant ausgelegtes Kommunikationssystem miteinander kommunizieren.

Die der Stelleinheit zugeordnete zweite Steuerkomponente kann sich mit einer oder mehreren weiteren Systemeinheiten in Kommunikation befinden. So kann eine weitere Systemeinheit einem Automatikgetriebe zugeordnet sein. Zweckmäßigerweise ermöglicht die dem Automatikgetriebe zugeordnete weitere Systemeinheit eine automatische Verriegelung der Feststell-Bremsanlage in einer dem Zustand "Parken" zugeordneten Gebriebestellung.

Die zuvor beschriebene Schutzschaltung kann in mindestens einer der Steuerkomponenten umfasst sein.

Außerdem kann die wenigstens eine zweite Steuerkomponente in die wenigstens eine Stelleinheit integriert sein und mindestens eine Schutzschaltung umfassen.

Des Weiteren wird ein elektronisches System zum Betreiben einer elektromechanischen Feststell-Bremsanlage eines Fahrzeugs definiert, das mindestens eine zuvor definierte Schutzfläche umfasst.

Diese mindestens eine Schutzfläche kann in mindestens einer der Steuerkomponenten umfasst sein.

Außerdem kann die wenigstens eine zweite Steuerkomponente in die wenigstens eine Stelleinheit integriert sein und mindestens eine Schutzfläche umfassen.

### Kurzbeschreibung der Zeichnungen

Fig. 1 zeigt einen Ausschnitt einer Leiterplatte auf der eine Schutzschaltung gemäß dem Patentanspruch 1 umfasst ist.
Fig. 2 zeigt ein Schaltbild, in dem ein Motor von einem Transistor angesteuert wird und zwischen einer Gateleitung und einer Drainleitung des Transistors ein ungewollter Kurzschluss vorliegt.
Fig. 3 zeigt ein Schaltbild einer vorteilhaften Ausgestaltung eines Transistors aus den Fig. 1 und 2.
Fig. 4 zeigt ein Schaltbild einer alternativen, vorteilhaften Ausgestaltung eines Transistors aus den Fig. 1 und 2.
Fig. 5 zeigt eine alternative Anordnung eines Ausschnitts aus Fig. 1.
Fig. 6 zeigt eine H-Brückenschaltung aus vier Transistoren zur Ansteuerung eines Motors.
Fig. 7 zeigt ein elektronisches System zum Betreiben einer elektromechanischen Feststell-Bremsanlage eines Fahrzeugs, das eine Schutzschaltung aus Fig. 1 umfasst.

### Detaillierte Beschreibung der Zeichnungen

Bei den im Folgenden beschriebenen Transistoren handelt es sich speziell um n-Kanal High-Side Feldeffekttransistoren. Feldeffekttransistoren ermöglichen auf Grund ihres großen Eingangswiderstandes eine leistungslose Steuerung eines Stromes durch eine Spannung. Folglich ist eine Ansteuerung eines Bauteils, das von einem der im Folgenden beschriebenen Transistoren angesteuert wird, im allgemeinen eine leistungslose Ansteuerung. Es sind jedoch auch andere Halbleiterschaltungen mit der vorgestellten Schutzanordnung absicherbar.

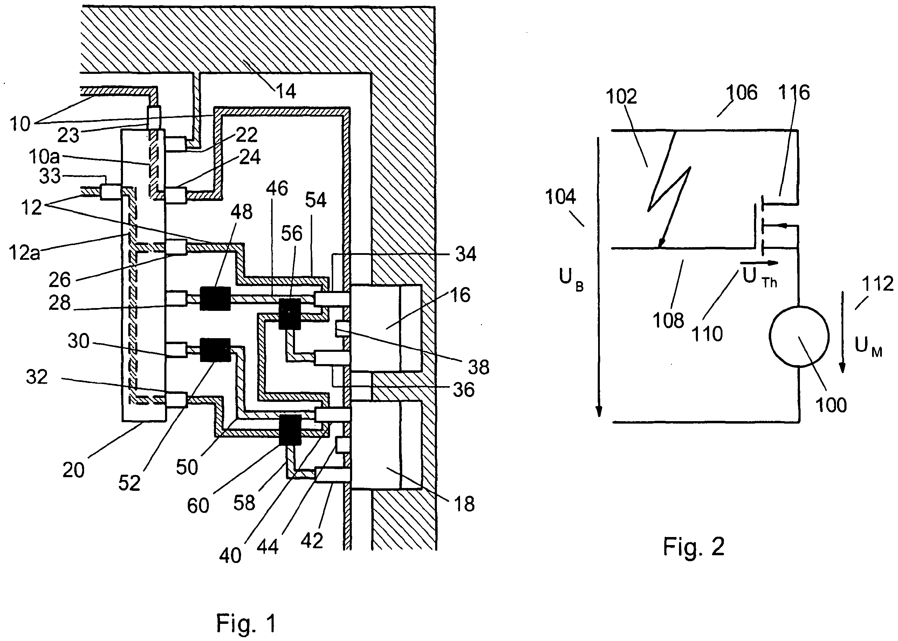

Fig. 1 zeigt einen Ausschnitt einer Leiterplatte auf der eine passive Schutzschaltung angeordnet ist. Diese umfasst zwei Leiterschleifen 10, 12. Beide Leiterschleifen 10, 12 haben ein Massepotential.

Auf dem Ausschnitt der Leiterplatte sind zudem ein Abschnitt einer Versorgungsspannungsleiterbahn 14, zwei Transistoren 16, 18 und ein Treiberbaustein 20 angeordnet.

Für die im Folgenden beschriebene Ausführungsform sind acht Anschlüsse des Treiberbausteins 20 relevant; ein Versorgungsspannungsanschluss 22, zwei Leiterschleifenanschlüsse 23, 24 für die erste Leiterschleife 10, drei Masseanschlüsse 26, 32, 33 für die zweite Leiterschleife 12 und zwei Verbindungsanschlüsse 28, 30 mit Versorgungsspannungspotential.

Der Versorgungsspannungsanschluss 22 ist leitend mit der Versorgungsspannungsleiterbahn 14 verbunden.

Eine erste Leiterschleife 10 ist mittels des Leiterschleifenanschlusses 23 mit dem Treiberbaustein 20 verbunden. In dem Treiberbaustein 20 bildet ein Abschnitt 10a der ersten Leiterschleife 10 eine Verbindung zwischen dem Leiterschleifenanschluss 23 und dem Leiterschleifenanschluss 24. Durch den Leiterschleifenanschluss 24 tritt die erste Leiterschleife 10 aus dem Treiberbaustein 20 aus.

Bevor die erste Leiterschleife 10 durch den Leiterschleifenanschluss 23 in den Treiberbaustein 20 eintritt und nachdem sie durch den Leiterschleifenanschluss 24 aus dem Treiberbaustein 20 austritt, verläuft sie in einem vorgegebenen Abstand dicht neben der Versorgungsspannungsleiterbahn 14.

Die beiden Transistoren 16, 18 weisen jeweils drei Anschlüsse auf, einen Gateanschluss 34, 40, einen Sourceanschluss 36, 42 und einen Drainanschluss 38, 44. Sie sind auf dem in Fig. 1 dargestellten Abschnitt der Leiterplatte so angeordnet, dass jeweils der Sourceanschluss 36, 42 und der Drainanschluss 38, 44 elektrisch leitend mit dem Abschnitt der Versorgungsspannungsleiterbahn 14 verbunden sind (Verbindung nicht dargestellt).

Hierfür ist der erste Transistor 16 mit seinem in Fig. 1 rechten Abschnitt auf dem Abschnitt der Versorgungsspannungsleiterbahn 14 angeordnet. Ein in Fig. 1 linker Abschnitt des Transistors 16 weist nach außen sichtbar den Gateanschluss 34, den Sourceanschluss 36 und den Drainanschluss 38 auf und zeigt von der Versorgungsspannungsleiterbahn weg in Richtung Treiberbaustein 20.

Ein zweiter Transistor 18 ist in Fig. 1 unterhalb des ersten Transistors 16 und mit Abstand zu diesem in analoger Weise aufgebaut und angeordnet.

Der Verbindungsanschluss 28 des Treiberbausteins 20 ist mit dem Gateanschluss 34 des ersten Transistors 16 elektrisch leitend verbunden. Diese elektrisch leitende Verbindung 46 umfasst einen Widerstand 48. Dieser dient als Ableitwiderstand. Durch ihn ist eine leistungsgetriebene Ansteuerung des ersten Transistors 16 sichergestellt.

Analog hierzu ist der Verbindungsanschluss 30 des Treiberbausteins 20 mit dem Gateanschluss 40 des zweiten Transistors 18 elektrisch leitend verbunden. Diese elektrisch leitende Verbindung 50 umfasst ebenfalls einen Widerstand 52, der als Ableitwiderstand dient und durdh den eine leistungsgetriebene Ansteuerung des zweiten Transistors 18 sichergestellt ist.

Zudem ist der Sourceanschluss 36 des ersten Transistors 16 elektrisch leitend mit der elektrisch leitenden Verbindung 46 verbunden. Auch diese Verbindung 54 umfasst einen Widerstand 56, der als Ableitwiderstand dient.

Analog ist auch der Sourceanschluss 42 des zweiten Transistors 18 elektrisch leitend mit der elektrisch leitenden Verbindung 50 verbunden. Diese Verbindung 58 umfasst ebenso einen Widerstand 60, der als Ableitwiderstand dient.

Die in einem vorgegebenen Abstand zur Versorgungsspannungsleiterbahn 14 verlaufende erste Leiterschleife 10 umschließt jeden der Gate-, Source- und Drainanschlüsse 34, 36, 38, 40, 42, 44 der beiden Transistoren 16, 18.

Zudem umschließt ein Teilabschnitt des Abschnitts 10a der ersten Leiterschleife 10, der innerhalb des Treiberbausteins 20 verläuft, die elektrisch leitende Verbindung des Treiberbausteins 20 mit der Versorgungsspannungsleiterbahn 14 (nicht dargestellt). Diese tritt durch den Versorgungsspannungsanschluss 22 in den Treiberbaustein 20 ein und versorgt in dieser Ausführungsform die Verbindungsanschlüsse 28, 30 mit Versorgungsspannung.

Es gilt sicherzustellen, dass die erste Leiterschleife 10 alle elektrischen Verbindungsleitungen umschließt, über die Schaltungs(bau)teile bzw. -gruppen auf der Leiterplatte mit Versorgungsspannung gespeist werden.

Mit dieser ersten Leiterschleife 10 ist eine Auswerteelektronik verbunden (nicht dargestellt). Diese dient der Überwachung des an der ersten Leiterschleife 10 anliegenden Spannungspotentials.

Die erste Leiterschleife 10 hat ein vorgegebenes Spannungspotential, das bevorzugt nicht über dem Versorgungsspannungspotential liegt. Sie kann Massepotential haben. Zudem hat die erste Leiterschleife 10 ein vorgegebenes Grenzpotential.

Das vorgegebene Grenzpotential liegt nennenswert über dem Versorgungsspannungspotential und wird bei Kurzschlüssen mit der Versorgungsspannungsleiterbahn 14 überschritten.

Überschreitet das Potential, das an den elektrischen Verbindungsleitungen anliegt, über die Schaltungs(bau)teile bzw. -gruppen auf der Leiterplatte mit Versorgungsspannung gespeist werden und die von der ersten Leiterschleife 10 umschlossen sind, dieses Grenzpotential, so wird dies von der Auswerteelektronik erkannt. Ausgehend von diesem Erkennen wird die Schaltung auf der Leiterplatte in einen sicheren Zustand gebracht. Dies erfolgt beispielsweise durch dauerhafte Deaktivierung von Bereichen der Leiterplatte, die von einem Kurzschluss betroffen sind.

Zusätzlich zu der ersten Leiterschleife 10 ist auf dem in Fig. 1 dargestellten Ausschnitt der Leiterplatte eine zweite Leiterschleife 12 vorgesehen. Diese ist mittels des Masseanschlusses 33 mit dem Treiberbaustein 20 verbunden. Ein Abschnitt 12a der zweiten Leiterschleife 12, der innerhalb des Treiberbausteins 20 verläuft, verzweigt sich und bildet jeweils eine Verbindung zu den Masseanschlüssen 26 und 32 des Treiberbausteins 20.

Durch den Masseanschluss 26 tritt die zweite Leiterschleife 12 aus dem Treiberbaustein 20 aus und durch den Masseanschluss 32 tritt die zweite Leiterschleife 12 wieder in den Treiberbaustein 20 ein.

In einem Abschnitt der zweiten Leiterschleife 12 außerhalb des Treiberbausteins 20 zwischen dessen Masseanschlüssen 26, 32 umschließt die zweite Leiterschleife 12 den Gateanschluss 34 des ersten Transistors 16 und den Gateanschluss 40 des zweiten Transistors 18.

Auf dem in Fig. 1 dargestellten Abschnitt der Leiterplatte ist durch diesen Verlauf der zweiten Leiterschleife 12 eine Abschirmung der beiden elektrisch leitenden Verbindungen 46, 50 gegenüber den beiden Transistoren 16, 18, der Versorgungsleiterbahn 14 und den Bereichen des Treiberbausteins 20 sichergestellt, die auch mit der Versorgungsspannungsleiterbahn 14 in Verbindung stehen.

Die zweite Leiterschleife 12 hat in dieser Ausführungsform Massepotential. Sie kann auch ein vorgegebenes Spannungspotential haben, das nicht über dem Versorgungsspannungspotential liegt. Zudem hat die erste Leiterschleife 12 ein vorgegebenes Grenzpotential. Sie ist derart widerstandsbehaftet, dass in ihr erst ab einer anliegenden Spannung, die nennenswert über der Betriebsspannung liegt, Strom fließt.

Das vorgegebene Grenzpotential liegt nennenswert über dem Versorgungsspannungspotential. Bei einem Kurzschluss zwischen den elektrischen Verbindungsleitungen 46, 50 wird dieses Grenzpotential überschritten.

Ist dies der Fall, so entzieht die zweite Leiterschleife 12, die die Gateanschlüsse 34, 40 umschließt, diesen Strom und setzt das Potential somit definiert herab.

Fig. 2 zeigt ein Schaltbild, in dem ein Motor 100 von einem Transistor 116 angesteuert wird und in dem ein Kurzschluss 102 zwischen einer Drainleitung 106 und einer Gateleitung 108 des Transistors 116 vorliegt.

Die in Fig. 2 dargestellte Schaltung ist durch eine Spannungsquelle (nicht dargestellt) mit Betriebsspannung U_{B} 104 versorgt.

Der Transistor 116 hat eine einstellbare bzw. herstellungsbedingte Schwellenspannung U_{Th} 110.

Durch den Kurzschluss 102 ist die am Motor 100 anliegende Spannung UM 112 gleich der Differenz aus Betriebsspannung U_{B} 104 und Schwellenspannung U_{Th} 110 des Transistors 116.

Je höher die Schwellenspannung U_{Th} 110 des Transistors 116, desto geringer ist die am Motor 100 anliegende Spannung UM 112.

Die Schwellenspannung U_{Th} des Transistors 116 ist so hoch, das die im Kurzschlussfall 102 am Motor 100 anliegende Spannung UM 112 ausreichend unterhalb der Betriebsspannung U_{B} des Motors 100 liegt. Dies verhindert eine unbeabsichtigte Ansteuerung des Motors 100.

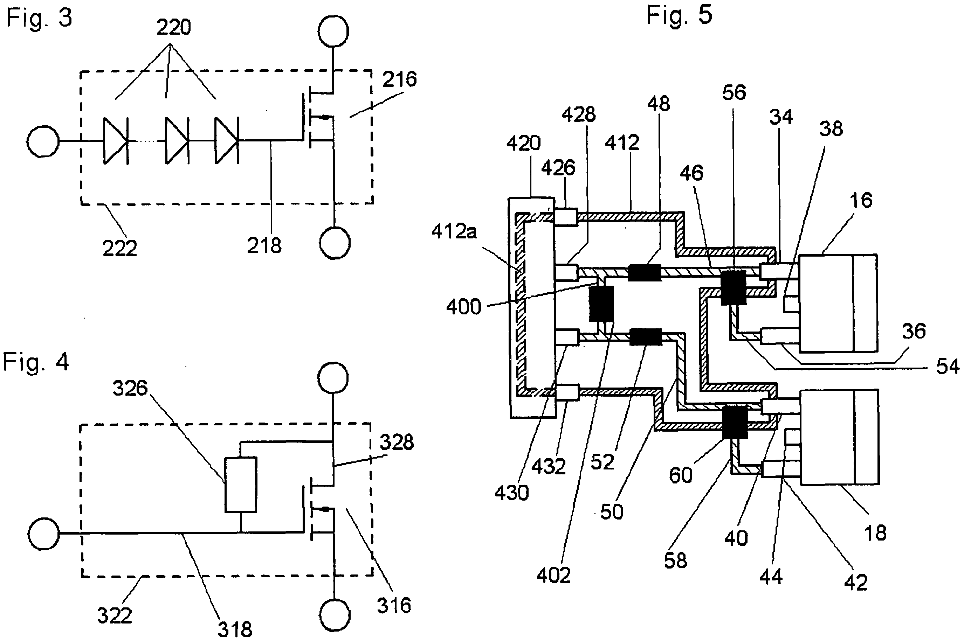

Fig. 3 zeigt ein Schaltbild einer vorteilhaften Ausgestaltung eines in den Fig. 1 und 2 umfassten Transistors.

Ein in Fig. 3 dargestellter Transistor 216 weist in seiner Gateleitung 218 eine oder mehrere Dioden 220 in Reihenschaltung (in Durchlassrichtung) auf. Diese ermöglichen es, die Schwellenspannung des Transistors 216 zu erhöhen, indem sie in der Gateleitung 218 einen definierten Spannungsabfall verursachen.

Je mehr Dioden 220 in der Gateleitung 218 umfasst sind, desto höher ist die Schwellenspannung des Transistors 116.

Um den Einfluss äußerer Störungen gering zu halten, sind diese Dioden 220 im Transistorgehäuse 222 integriert.

Fig. 4 zeigt ein Schaltbild einer alternativen vorteilhaften Ausgestaltung eines in den Fig. 1 und 2 umfassten Transistors.

Ein in Fig. 4 dargestellter Transistor 316 umfasst einen Spannungsteiler.

Der Spannungsteiler ist durch einen zwischen der Gateleitung 318 und der Drainleitung 328 des Transistors 316 angeordneten Widerstand 326 gebildet.

Durch diese Anordnung wird ein Teil der Ausgangsspannung des Transistors 316 über den Widerstand 326 zur Eingangsspannung des Transistors 316 addiert. Da die dargestellte Schaltung ein invertierender Verstärker ist, verkleinert sich durch den Spannungsteiler die Eingangsspannung des Transistors 316.

Um den Einfluss äußerer Störungen gering zu halten, ist auch die Spannungsteileranordnung im Transistorgehäuse 322 integriert.

Fig. 5 zeigt eine alternative Anordnung eines Ausschnitts aus Fig. 1, auf dem nur die zweite der beiden Leiterschleifen 10, 12 dargestellt ist.

Die Anordnung in Fig. 5 ist bis auf wenige Ausnahmen identisch mit der Darstellung aus Fig. 1.

In Fig. 5 fehlt die Versorgungsspannungsleiterbahn und die erste Leiterschleife. Für die im Folgenden beschriebene Ausführungsform sind nur zwei Masseanschlüsse 426, 432 und zwei Verbindungsanschlüsse 428, 430 des Treiberbausteins 420 relevant. Diese entsprechen den Masseanschlüssen 26, 32 und den Verbindungsanschlüssen 28, 30 aus Fig. 1.

Die zweite Leiterschleife 412 hat, wie in Fig. 1, einen Abschnitt 412a, der im Treiberbaustein 420 verläuft. Dieser Abschnitt 412a bildet jedoch innerhalb des Treiberbausteins 420 nur eine elektrisch leitende Verbindung zwischen den beiden Anschlüssen 426 und 432.

Auch hier hat die zweite Leiterschleife 412 ein vorgegebenes Spannungspotential, das nicht über dem Versorgungsspannungspotential liegt. Sie kann Massepotential haben. Zudem hat sie ein vorgegebenes Grenzpotential.

Die elektrisch leitenden Verbindungen 46, 50 zwischen den Transistoren 16, 18 und den Verbindungsanschlüssen 428, 430 des Treiberbausteins 420 sind analog zu den bezüglich Fig. 1 beschriebenen. Die einzige Ausnahme bildet eine Kopplung 400 zwischen den elektrisch leitenden Verbindungen 46 und 50. Als Kopplung 400 ist eine elektrisch leitende Verbindung zwischen den beiden elektrisch leitenden Verbindungen 46 und 50 gebildet, direkt nach den Verbindungsanschlüssen 428, 230 und vor den Ableitwiderständen 48, 52. Diese elektrisch leitende Verbindung umfasst einen Kopplungswiderstand 402.

Der Kopplungswiderstand 402 dieser Kopplung 400 ist so gewählt, dass es bei einer unbeabsichtigten Ansteuerung, also im Kurzschlussfall, zu einer Ansteuerung beider Transistoren 16, 18 kommt. Dies verringert die Spannungsdifferenz in der Schaltung, die ein Maß für die kritische Auswirkung im Kurzschlussfall ist.

Liegt hingegen kein Kurzschlussfall vor, so wird nur derjenige der beiden Transistoren 16 oder 18 angesteuert, dessen Ansteuerung auch beabsichtigt ist.

Die zweite Leiterschleife 412 hat in der Anordnung aus Fig. 5 dieselbe Funktion wie bereits für die Anordnung aus Fig. 1 beschrieben.

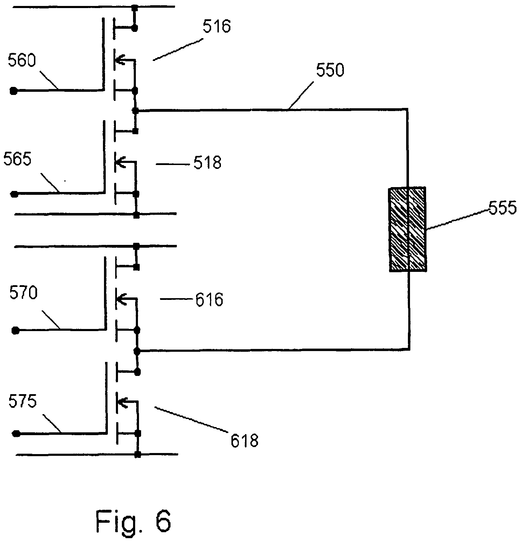

Fig. 6 zeigt eine H-Brückenschaltung aus vier Transistoren 516, 518, 616, 618 zur Ansteuerung eines Motors.

In der H-Brückenschaltung sind ein Sourceanschluss 536 des ersten Transistors 516 und ein Drainanschluss 544 des zweiten Transistors 518 elektrisch leitend verbunden. Ebenso sind ein Sourceanschluss 636 des dritten Transistors 616 und ein Drainanschluss 644 des vierten Transistors 618 elektrisch leitend verbunden.

Zwischen diesen beiden Verbindungen ist eine weitere elektrisch leitende Verbindung 550 gebildet. Diese bildet in einem Abschnitt Wicklungen einer Spule 555 eines Elektromotors.

Der Transistor 516 kann dem Transistor 16 aus Fig. 1 entsprechen und der Transistor 518 kann dem Transistor 18 aus Fig. 1 entsprechen. Folglich ist die Ausführungsform aus Fig. 1 eine Hälfte einer H-Brückenschaltung.

Wie bezüglich den Fig. 3 und 4 beschrieben, weisen die vier Transistoren 516, 518, 616, 618 in ihren Gateleitungen 560, 565, 570, 575 eine oder mehrere Dioden (in Durchlassrichtung) oder einen Spannungsteiler auf (hier nicht dargestellt).

Mittels der vier Transistoren 516, 518, 616, 618 kann der Motor in zwei Richtungen drehend betrieben werden.

Liegt in den Gateleitungen 560, 575 des ersten und des vierten Transistors 516, 618 Betriebsspannung an, so fließt in der elektrisch leitenden Verbindung 550 ein gerichteter Strom. Dieser gerichtete Strom fließt durch die Wicklungen der Spule 555 des Motors. Der Motor ist folglich in einer ersten Richtung in Betrieb.

Liegt in den Gateleitungen 565, 570 des zweiten und des dritten Transistors 518, 616 Betriebsspannung an, so fließt in der elektrisch leitenden Verbindung 550 ein entgegengesetzt gerichteter Strom. Dieser entgegengesetzt gerichtete Strom fließt durch die Wicklungen der Spule 555 des Motors. Der Motor ist folglich in einer zweiten, der ersten Richtung entgegengesetzten Richtung in Betrieb.

Um den Motor vor einer unbeabsichtigten Ansteuerung im Kurzschlussfall zu schützen, ist zwischen den Gateleitungen 560, 565 des ersten und des zweiten Transistors 516, 518 eine erste Kopplung (nicht dargestellt), wie für Fig. 5 beschrieben, vorgesehen. Diese erste Kopplung umfasst, wie für Fig. 5 beschrieben, einen Kopplungswiderstand.

Ebenso ist zwischen den Gateleitungen 570, 575 des dritten und des vierten Transistors 616, 618 eine zweite Kopplung (nicht dargestellt) vorgesehen. Diese zweite Kopplung umfasst ebenfalls einen Kopplungswiderstand.

Die Kopplungswiderstände sind für jede der beiden Kopplungen ausreichend groß gewählt, dass jeder Transistor 516, 518, 616, 618 gezielt ansteuerbar ist solange kein Kurzschluss vorliegt. Die Kopplungswiderstände sperren also, solange eine Spannung anliegt, die kleiner oder gleich der Betriebsspannung ist.

Ein Kurzschlusspotential liegt nennenswert über dem Betriebspotential. Daher werden im Kurzschlussfall zwischen der Gateleitung 560 und einer Drainleitung des ersten Transistors 516 durch die erste Kopplung der erste und der zweite Transistor 516, 518 angesteuert. Gleiches gilt für einen Kurzschlussfall zwischen der Gateleitung 570 und einer Drainleitung des zweiten Transistors 518. Im Kurzschlussfall zwischen der Gateleitung 565 und einer Drainleitung des dritten Transistors 616 werden durch die zweite Kopplung der dritte und der vierte Transistor 616, 618 angesteuert. Gleiches gilt für einen Kurzschlussfall zwischen der Gateleitung 575 und einer Drainleitung des vierten Transistors 618.

Diese Doppelansteuerung des ersten und zweiten bzw. des dritten und vierten Transistors verringert die Spannungsdifferenz in der H-Brückenschaltung und verhindert somit die Ansteuerung des Motors.

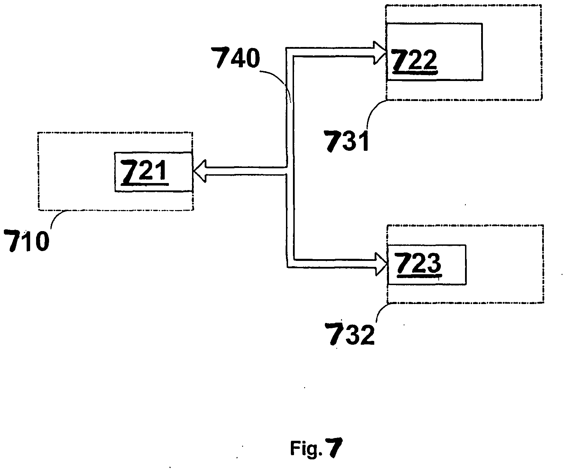

Fig. 7 zeigt ein elektronisches System zum Betreiben einer elektromechanischen Feststell-Bremsanlage eines Fahrzeugs, das eine bezüglich Fig. 1 beschriebene Schutzschaltung umfasst.

In eine Systemeinheit 710, die hier als Eingabeeinheit zum Erfassen eines Fahrerwunsches zur Betätigung der Feststell-Bremsanlage ausgebildet ist, ist eine elektronische Steuerkomponente 721 integriert.

Diese elektronische Steuerkomponente 721 umfasst als so bezeichneter "Master" eine zentrale Rechnereinheit, die den Fahrerwunsch auswertet und die Ansteuerung der Feststell-Bremsanlage bestimmt. Dazu wirkt die elektronische Steuerkomponente 721 durch Datenaustausch über ein Kommunikationssystem 740, z.B. einen CAN-Bus oder einen LIN-Bus, mit anderen, als "Slave" bezeichneten, elektronischen Steuerkomponenten 722 und 723 zusammen. Diese elektronischen Steuerkomponenten 722, 723 sind in Stelleinheiten 731, 732 integriert, die den Bremsen des Fahrzeugs zugeordnet sind. Aufgrund der Integration der elektronischen Steuerkomponenten 722, 723 stellen die Stelleinheiten 731, 732 so bezeichnete "Smart"-Aktuatoren dar.

In den elektronischen Steuerkomponenten 722, 723 der Stelleinheiten 731, 732 sind Schutzschaltungen (nicht dargestellt) gemäß Fig. 1 umfasst.

In einer Variante ist ebenso in der elektronischen Steuerkomponente 721 der Eingabeeinheit 710 eine Schutzschaltung (nicht dargestellt) gemäß Fig. 1 umfasst.

## Patentansprüche

1. Auf einer Leiterplatte angeordnete Schutzschaltung, mit
- mindestens einer Versorgungsspannungsleiterbahn (14) auf der Leiterplatte,
- mindestens einem Halbleiterschalter (16) mit Anschlüssen (34, 36, 38) auf der Leiterplatte und
- mindestens einem Ansteuerbaustein (20) mit mindestens einem Anschluss (28) auf der Leiterplatte, wobei ein erster Anschluss (28) des Ansteuerbausteins (20) und ein erster Anschluss (34) des Halbleiterschalters (16) elektrisch leitend verbunden sind,
und die Schutzschaltung **gekennzeichnet ist durch**
- eine erste mit einer Auswerteelektronik verbundene Leiterschleife (10), die auf der Leiterplatte so angeordnet ist, dass sie eine elektrisch leitende Verbindung an dem Anschluss (28) zwischen der Versorgungsspannungsleiterbahn (14) und dem Ansteuerbaustein (20) umschließt, und
- eine zweite Leiterschleife (12), die auf der Leiterplatte so angeordnet ist, dass sie die elektrisch leitende Verbindung (46) zwischen dem ersten Anschluss (28) des Ansteuerbausteins (20) und dem ersten Anschluss (34) des Halbleiterschalters (16) von dem Halbleiterschalter (16) und zumindest von den Bereichen des Ansteuerbausteins (20) abschirmt, die auch mit der Versorgungsspannungsleiterbahn (14) in Verbindung stehen, und dass sie den Anschluss (28) des Steuerbausteins (20) und den ersten Anschluss (34) des Halbleiterschalters (16) vollständig umschließt.

2. Schutzschaltung nach Anspruch 1, wobei
- der mindestens eine Halbleiterschalter (16) ein nachgeschaltetes Bauteil (100) ansteuert, und wobei
- bei einer von einem Kurzschluss ausgelösten Ansteuerung des nachgeschalteten Bauteils (100) eine an dem nachgeschalteten Bauteil (100) anliegende Spannung U_{M} (112) zumindest durch eine Schwellenspannung U_{Th} des mindestens einen Halbleiterschalters (16) und eine zwischen der Versorgungsleiterbahn (14) und einem Massepotential anliegenden Betriebsspannung U_{B} (104) bestimmt wird, und wobei
- die Schwellenspannung U_{Th} (110) des mindestens einen Halbleiterschalters (16) so gewählt ist, dass bei der von dem Kurzschluss (102) ausgelösten Ansteuerung des nachgeschalteten Bauteils (100) die an dem nachgeschalteten Bauteil anliegende Spannung U_{M} (112) nicht ausreicht, um das nachgeschaltete Bauteil (100) zu betreiben und/oder zu beschädigen, und/oder
- wobei der Halbleiterschalter (16) und der Ansteuerbaustein (20) jeweils einen zweiten Anschluss (22) haben und der zweite Anschluss des Halbleiterschalters (16) sowie der zweite Anschluss (22) des Ansteuerbausteins (20) elektrisch leitend mit der Versorgungsspannungsleiterbahn (14) verbunden sind, und/oder
- wobei der Ansteuerbaustein (20) einen dritten und einen vierten Anschluss (26, 32) hat und der dritte sowie der vierte Anschluss (26, 32) des Ansteuerbausteins (20) ein Massepotential haben, und/oder
- wobei der Ansteuerbaustein (20) einen dritten und einen vierten Anschluss (26, 32) hat und der erste Anschluss (28) des Ansteuerbausteins (20) zwischen dem dritten und dem vierten Anschluss (26, 32) des Ansteuerbausteins (20) angeordnet ist.

3. Schutzschaltung nach Anspruch 1, wobei der Ansteuerbaustein (20) einen dritten und einen vierten Anschluss (26, 32) hat und ein Anfang der zweiten Leiterschleife (12) mit dem dritten Anschluss (26) des Ansteuerbausteins (20) elektrisch leitend verbunden ist und ein Ende der zweiten Leiterschleife (12) mit dem vierten Anschluss (32) des Ansteuerbausteins (20) elektrisch leitend verbunden ist.

4. Schutzschaltung nach Anspruch 3, wobei die zweite Leiterschleife (12) durch die Verbindung der Leiterschleife (12) mit dem dritten und vierten Anschluss (26, 32) des Ansteuerbausteins (20) eine geschlossene, zweite Leiterschleife (12) ist.

5. Schutzschaltung nach Anspruch 1, wobei die erste und die zweite Leiterschleife (10, 12) zumindest abschnittsweise frei liegen, und/oder
wobei der Halbleiterschalter (16) ein Transistor und der erste Anschluss (34) des Halbleiterschalters (16) ein Gateanschluss des Transistors ist.

6. Schutzschaltung nach Anspruch 5, wobei mindestens eine Diode (220) in der elektrischen Verbindung (218) zwischen dem ersten Anschluss des Ansteuerbausteins und dem Gateanschluss des Transistors (216) umfasst ist und/oder mindestens ein Spannungsteiler (324, 326) im Transistor (216) vorgesehen ist, und/oder wobei der Transistor (16) einen dritten Anschluss (36) umfasst und der dritte Anschluss (36) ein Sourceanschluss des Transistors (16) ist.

7. Schutzschaltung nach den Ansprüchen 1, 5 und 6, wobei zwischen dem Gateanschluss (34) des Transistors (16) und dem ersten Anschluss (28) des Ansteuerbausteins (20) eine elektrisch leitende Verbindung (46) ausgebildet ist und der Sourceanschluss (36) des Transistors elektrisch leitend mit dieser elektrisch leitenden Verbindung (46) verbunden ist, und wobei vorzugsweise
die elektrisch leitende Verbindung (54) zwischen dem Sourceanschluss (36) des Transistors (16) und der elektrisch leitenden Verbindung (46) zwischen dem Gateanschluss (34) des Transistors (16) und dem ersten Anschluss (28) des Ansteuerbausteins (20) mindestens einen Ableitwiderstand (56) umfasst.

8. Schutzschaltung nach den Ansprüchen 1 und 5, wobei die elektrisch leitende Verbindung (46) zwischen dem Gateanschluss (34) des Transistors (16) und dem ersten Anschluss (28) des Ansteuerbausteins (20) mindestens einen Ableitwiderstand (48) umfasst.

9. Schutzschaltung nachd Anspruch 2 wobei
- auf der Leiterplatte mindestens zwei Transistoren (16, 18) umfasst sind,
- der Ansteuerbaustein (20) mindestens einen fünften Anschluss (30) aufweist,
- der erste und der fünfte Anschluss (28, 30) des Ansteuerbausteins (20) zwischen dem dritten und dem vierten Anschluss (24, 32) angeordnet sind, und
- jeweils zwischen zwei elektrischen Verbindungen (46, 50), die zwischen dem Gateanschluss (34) eines ersten Transistors (16) und dem ersten Anschluss (28) des Ansteuerbausteins (20) und zwischen dem Gateanschluss (40) eines zweiten Transistors (18) und dem fünften Anschluss (30) des Ansteuerbausteins (20) ausgebildet sind, eine elektrisch leitende Kopplung (400) ausgebildet ist, und wobei vorzugsweise
- die elektrisch leitende Kopplung (400) mindestens einen Kopplungswiderstand (402) umfasst.

10. Schutzschaltung nach den Ansprüchen 1, 5 und 9, wobei die zweite Leitungsschleife (12) die elektrisch leitenden Verbindungen (46, 50), die jeweils zwischen einem Gateanschluss (34, 40) eines Transistors (16, 18) und einem Anschluss (28, 30) des Ansteuerbausteins (20) ausgebildet sind, von dem Transistor (16, 18) und zumindest von den Bereichen des Ansteuerbausteins (20) abschirmt, die mit der Versorgungsspannungsleiterbahn (14) in Verbindung stehen.

11. Zwischen zwei Leiterplatten angeordnete Schutzfläche, wobei die Leiterplatten
- Schutzschaltungen nach einem der vorangegangenen Ansprüche aufweisen,
- auf jeder der zwei Leiterplatten
o mindestes eine Versorgungsspannungsleiterbahn,
o mindestens ein Halbleiterschalter und
o mindestens ein Ansteuerbaustein
angeordnet ist,
- eine erste der zwei Leiterplatten über einer zweiten Leiterplatte angeordnet ist und
- die erste und die zweite Leiterplatte mechanisch und/oder elektrisch miteinander verbunden sind,
und die Schutzfläche **gekennzeichnet ist durch** eine Leiterfläche, die zwischen der ersten und der zweiten Leiterplatte angeordnet ist und die erste und die zweite Leiterplatte gegeneinander abschirmt, und wobei vorzugsweise,
die Leiterfläche Massepotential hat.

12. Elektronisches System zum Betreiben einer elektromechanischen Feststell-Bremsanlage eines Fahrzeugs, mit wenigstens einer Eingabeeinheit (710) zum Erfassen eines Fahrerwunsches, der von einer Steuereinheit ausgewertet wird, die wenigstens eine Stelleinheit (731, 732) zum Betätigen wenigstens einer Bremse ansteuert, wobei die Steuereinheit wenigstens zwei Steuerkomponenten (721, 722, 723) umfasst, von denen eine erste Steuerkomponente (721) der Eingabeeinheit (710) zugeordnet ist und wenigstens eine zweite Steuerkomponente (722, 723) der wenigstens einen Stelleinheit (731, 732) zugeordnet ist, wobei das elektronische System mindestens eine Schutzschaltung nach einem der Ansprüche 1 bis 10 umfasst.

13. Elektronisches System nach Anspruch 12, wobei die Schutzschaltung nach einem der Ansprüche 1 bis 10 in mindestens einer der Steuerkomponenten (721, 722, 723) umfasst ist, und/oder wobei
die wenigstens eine zweite Steuerkomponente (722, 723) in die wenigstens eine Stelleinheit (731, 732) integriert ist und mindestens eine Schutzschaltung nach einem der Ansprüche 1 bis 10 umfasst.

14. Elektronisches System zum Betreiben einer elektromechanischen Feststell-Bremsanlage eines Fahrzeugs, mit wenigstens einer Eingabeeinheit (710) zum Erfassen eines Fahrerwunsches, der von einer Steuereinheit ausgewertet wird, die wenigstens eine Stelleinheit (731, 732) zum Betätigen wenigstens einer Bremse ansteuert, wobei die Steuereinheit wenigstens zwei Steuerkomponenten (721, 722, 723) umfasst, von denen eine erste Steuerkomponente (721) der Eingabeeinheit (710) zugeordnet ist und wenigstens eine zweite Steuerkomponente (722, 723) der wenigstens einen Stelleinheit (731, 732) zugeordnet ist, wobei das elektronische System mindestens eine Schutzfläche nach Anspruche 11 umfasst.

15. Elektronisches System nach Anspruch 14, wobei die Schutzfläche nach Anspruch 11 in mindestens einer der Steuerkomponenten (721, 722, 723) umfasst ist, und/oder
wobei die wenigstens eine zweite Steuerkomponente (722, 723) in die wenigstens eine Stelleinheit (731, 732) integriert ist und mindestens eine Schutzfläche nach Anspruch 11 umfasst.

## Claims

1. Protective circuit (10, 12) arranged on a printed circuit board, with
- at least one supply voltage track (14) on the printed circuit board,
- at least one semiconductor switch (16) with terminals (34, 36, 38) on the printed circuit board, and
- at least one control component (20) with at least one terminal (28) on the printed circuit board, a first terminal (28) of the control component (20) and a first terminal (34) of the semiconductor switch (16) being connected electrically,
and the protective circuit (10, 12) is **characterized by**
- a first conductor loop (10) connected to an electronic evaluation unit, wherein the first conductor loop (10) is arranged on the printed circuit board so that it surrounds an electrically conducting connection at the terminal (28) between the supply voltage track (14) and the control component (20), and
- a second conductor loop (12), which is arranged on the printed circuit board so that it screens the electrically conducting connection (46) between the first terminal (28) of the control component (20) and the first terminal (34) of the semiconductor switch (16) from the semiconductor switch (16) and at least from those regions of the control component (20) which are also connected to the supply voltage track (14), and that it completely surrounds the terminal (28) of the control component (20) and the first terminal (34) of the semiconductor switch (16).

2. Protective circuit according to Claim 1, wherein
- the at least one semiconductor switch (16) controls a downstream component (100), and wherein
- if activation of the downstream component (100) is triggered by a short-circuit, a voltage UM (112) applied to the downstream component (100) is determined at least by a threshold voltage UTh of the at least one semiconductor switch (16) and an operating voltage UB (104) applied between the supply voltage track (14) and an earth potential, and wherein
- the threshold voltage (UTh) (110) of the at least one semiconductor switch (16) is chosen so that, if the activation of the downstream component (100) is triggered by the short-circuit (102), the voltage U_{M} (112) applied to the downstream component (100) is insufficient to operate and/or damage the component (100), and/or
- wherein the semiconductor switch (16) and the control component (20) each have a second terminal (22), and the second terminal of the semiconductor switch (16) and the second terminal (22) of the control component (20) are connected electrically to the supply voltage track (14), and/or
- wherein the control component (20) has a third and a fourth terminal (26, 32), and the third and fourth terminals (26, 32) of the control component (20) have an earth potential, and/or
- wherein the control component (20) has a third and a fourth terminal (26, 32), and the first terminal (28) of the control component (20) is arranged between the third and fourth terminal (26, 32) of the control component (20).

3. Protective circuit according to Claim 1, wherein the control component (20) has a third and a fourth terminal (26, 32), and a start of the second conductor loop (12) is connected electrically to the third terminal (26) of the control component (20), and an end of the second conductor loop (12) is connected electrically to the fourth terminal (32) of the control component (20).

4. Protective circuit according to Claim 3, wherein the second conductor loop (12) is a closed second conductor loop (12), because of the connection of the conductor loop (12) to the third and fourth terminal (26, 32) of the control component (20),

5. Protective circuit according to Claim 1, wherein the first and second conductor loops (10, 12) are bare at least in sections, and/or
wherein the semiconductor switch (16) is a transistor, and the first terminal (34) of the semiconductor switch (16) is a gate terminal of the transistor.

6. Protective circuit according to Claim 5, wherein at least one diode (220) is included in the electrical connection (218) between the first terminal of the control component and the gate terminal of the transistor (216), and/or at least one voltage divider (324, 326) is provided in the transistor (216), and/or
wherein the transistor (16) includes a third terminal (36), and the third terminal (36) is a source terminal of the transistor (16).

7. Protective circuit according to Claims 1, 5 and 6, wherein between the gate terminal (34) of the transistor (16) and the first terminal (28) of the control component (20), an electrically conducting connection (46) is formed, and the source terminal (36) of the transistor is connected electrically to this electrically conducting connection (46), and wherein preferably.
the electrically conducting connection (54) between the source terminal (36) of the transistor (16) and the electrically conducting connection (46) between the gate terminal (34) of the transistor (16) and the first terminal (28) of the control component (20) includes at least one discharge resistor (56).

8. Protective circuit according to Claims 1 and 5, wherein the electrically conducting connection (46) between the gate terminal (34) of the transistor (16) and the first terminal (28) of the control component (20) includes at least one discharge resistor (48).

9. Protective circuit according to Claim 2, wherein
- at least two transistors (16, 18) are included on the printed circuit board,
- the control component (20) has at least one fifth terminal (30),
- the first and fifth terminals (28, 30) of the control component (20) are arranged between the third and fourth terminals (24, 32), and
in each case between two electrical connections (46, 50), which are formed between the gate terminal (34) of a first transistor (16) and the first terminal (28) of the control component (20) and between the gate terminal (40) of a second transistor (18) and the fifth terminal (30) of the control component (20), an electrically conducting coupling (400) is formed, and wherein preferably the electrically conducting coupling (400) includes at least one coupling resistor (402).

10. Protective circuit according to Claims 1, 5 and 9, wherein the second conduction loop (12) screens the electrically conducting connections (46, 50) which are formed between a gate terminal (34, 40) of a transistor (16, 18) and a terminal (28, 30) of the control component (20) from the transistor (16, 18), and at least from those regions of the control component (20) which are connected to the supply voltage track (14).

11. Protective surface which is arranged between two printed circuit boards
- the printed circuit boards having protective circuits according to one of the preceding claims,
- on each of the two printed circuit boards
o at least one supply voltage track,
o at least one semiconductor switch, and
o at least one control component
being arranged,
- a first of the two printed circuit boards being arranged over a second printed circuit board, and
- the first and second printed circuit boards being connected to each other mechanically and/or electrically,
and the protective surface is **characterized by** a conductor surface, which is arranged between the first and second printed circuit boards and screens the first and second printed circuit boards from each other, and wherein preferably
the conductor surface has earth potential.

12. Electronic system for operating an electromechanical parking brake system of a vehicle, with at least one input unit (710) to capture a driver's wish, which is evaluated by a control unit which controls at least one positioning unit (731, 732) to actuate at least one brake, the control unit including at least two control components (721, 722, 723), of which a first control component (721) is assigned to the input unit (710), and at least one second control component (722, 723) is assigned to the at least one positioning unit (731, 732), and the electronic system having at least one protective circuit according to one of Claims 1 to 10.

13. Electronic system according to Claim 12, wherein the protective circuit according to one of Claims 1 to 10 is included in at least one of the control components (721, 722, 723), and/or wherein
the at least one second control component (722, 723) is integrated in the at least one positioning unit (731, 732), and includes at least one protective circuit according to one of Claims 1 to 10.

14. Electronic system for operating an electromechanical parking brake system of a vehicle, with at least one input unit (710) to capture a driver's wish, which is evaluated by a control unit which controls at least one positioning unit (731, 732) to actuate at least one brake, the control unit including at least two control components (721, 722, 723), of which a first control component (721) is assigned to the input unit (710), and at least one second control component (722, 723) is assigned to the at least one positioning unit (731, 732), and the electronic system having at least one protective surface according to Claim 11.

15. Electronic system according to Claim 14, wherein the protective surface according to Claim 11 is included in at least one of the control components (721, 722, 723), and/or
wherein the at least one second control component (722, 723) is integrated in the at least one positioning unit (731, 732), and includes at least one protective surface according to Claim 11.

## Revendications

1. Circuit de protection disposé sur une carte à circuits imprimés, comprenant
- au moins une piste conductrice de tension d'alimentation (14) sur la carte à circuits imprimés,
- au moins un commutateur à semi-conducteurs (16) avec des raccords (34, 36, 38) sur la carte à circuits imprimés et
- au moins un composant de commande (20) avec au moins un raccord (28) sur la carte à circuits imprimés, un premier raccord (28) dudit composant de commande (20) et un premier raccord (34) dudit commutateur à semi-conducteurs (16) étant reliés de manière électroconductrice,
et le circuit de protection étant **caractérisé par**
- une première boucle conductrice (10) qui est raccordée à un dispositif électronique d'évaluation et est disposée de telle façon sur la carte à circuits imprimés qu'elle entoure une liaison électroconductrice au raccord (28) entre ladite piste conductrice de tension d'alimentation (14) et le composant de commande (20), et par
- une deuxième boucle conductrice (12) qui est disposée de telle façon sur la carte à circuits imprimés qu'elle protège le commutateur à semi-conducteurs (16) et au moins les zones du composant de commande (20) également raccordées à la piste conductrice de tension d'alimentation (14) de la liaison électroconductrice (46) entre ledit premier raccord (28) du composant de commande (20) et ledit premier raccord (34) du commutateur à semi-conducteurs (16), et qu'elle entoure complètement le raccord (28) du composant de commande (20) et le premier raccord (34) du commutateur à semi-conducteurs (16).

2. Circuit de protection selon la revendication 1, dans le cadre duquel
- ledit commutateur à semi-conducteurs (16) commande un composant (100) monté en aval, et dans le cadre duquel
- lors d'une activation du composant monté en aval (100) déclenchée par court-circuit, une tension U_{M} (112) présente au composant monté en aval (100) est déterminée au moins par une tension de seuil U_{Th} dudit commutateur à semi-conducteurs (16) et une tension de service U_{B} (104) présente entre la piste conductrice de tension d'alimentation (14) et un potentiel de masse, et dans le cadre duquel
- la tension de seuil U_{TH} (110) dudit commutateur à semi-conducteurs (16) est choisie de telle manière que, lors de l'activation du composant monté en aval (100) déclenchée par court-circuit (102), la tension U_{M} (112) présente au composant monté en aval ne suffit pas pour faire fonctionner et/ou endommager le composant monté en aval (100), et/ou
- dans le cadre duquel le commutateur à semi-conducteurs (16) et le composant de commande (20) possèdent chacun un deuxième raccord (22), et le deuxième raccord du commutateur à semi-conducteurs (16) et le deuxième raccord (22) du composant de commande (20) sont reliés de manière électroconductrice à la piste conductrice de tension d'alimentation (14), et/ou
- dans le cadre duquel le composant de commande (20) possède un troisième et un quatrième raccord (26, 32), et le troisième et le quatrième raccord (26, 32) du composant de commande (20) possèdent un potentiel de masse, et/ou
- dans le cadre duquel le composant de commande (20) possède un troisième et un quatrième raccord (26, 32), et le premier raccord (28) du composant de commande (20) est disposé entre le troisième et le quatrième raccord (26, 32) du composant de commande (20).

3. Circuit de protection selon la revendication 1, dans le cadre duquel le composant de commande (20) possède un troisième et un quatrième raccord (26, 32), et un début de la deuxième boucle conductrice (12) est relié de manière électroconductrice au troisième raccord (26) du composant de commande (20), et une fin de la deuxième boucle conductrice (12) est reliée de manière électroconductrice au quatrième raccord (32) du composant de commande (20).

4. Circuit de protection selon la revendication 3, dans le cadre duquel la deuxième boucle conductrice (12) est une deuxième boucle conductrice (12) fermée du fait de son raccordement au troisième et au quatrième raccord (26, 32) du composant de commande (20).

5. Circuit de protection selon la revendication 1, dans le cadre duquel la première et la deuxième boucle conductrice (10, 12) se trouvent au moins par endroits à découvert, et/ou
dans le cadre duquel le commutateur à semi-conducteurs (16) est un transistor, et le premier raccord (34) du commutateur à semi-conducteurs (16) une borne de grille du transistor.

6. Circuit de protection selon la revendication 5, dans le cadre duquel au moins une diode (220) est comprise dans la liaison électrique (218) entre le premier raccord du composant de commande et la borne de grille du transistor (216), et/ou au moins un diviseur de tension (324, 326) est prévu dans le transistor (216), et/ou dans le cadre duquel le transistor (16) comprend un troisième raccord (36), et ce troisième raccord (36) est un raccord de source du transistor (16).

7. Circuit de protection selon les revendications 1, 5 et 6, dans le cadre duquel une liaison électroconductrice (46) est réalisée entre la borne de grille (34) du transistor (16) et le premier raccord (28) du composant de commande (20), et le raccord de source (36) du transistor est relié de manière électroconductrice à cette liaison électroconductrice (46), et dans le cadre duquel
la liaison électroconductrice (54) entre le raccord de source (36) du transistor (16) et la liaison électroconductrice (46) entre la borne de grille du transistor (16) et le premier raccord (28) du composant de commande (20) comprend de préférence au moins une résistance de dérivation (56).

8. Circuit de protection selon les revendications 1 et 5, dans le cadre duquel la liaison électroconductrice (46) entre la borne de grille (34) du transistor (16) et le premier raccord (28) du composant de commande (20) comprend au moins une résistance de dérivation (48).

9. Circuit de protection selon la revendication 2, dans le cadre duquel
- au moins deux transistors (16, 18) sont montés sur la carte à circuits imprimés,
- le composant de commande (20) présente au moins un cinquième raccord (30),
- le premier et le cinquième raccord (28, 30) du composant de commande (20) sont disposés entre le troisième et le quatrième raccord (24, 32), et
- un couplage électroconducteur (400) est réalisé à chaque fois entre deux liaisons électriques (46, 50) qui sont disposées entre la borne de grille (34) d'un premier transistor (16) et le premier raccord (28) du composant de commande (20) et entre la borne de grille (40) d'un deuxième transistor (18) et le cinquième raccord (30) du composant de commande (20), et dans le cadre duquel
- le couplage électroconducteur (400) comprend de préférence au moins une résistance de couplage (402).

10. Circuit de protection selon les revendications 1, 5 et 9, dans le cadre duquel la deuxième boucle conductrice (12) protège le transistor (16, 18) et au moins les zones du composant de commande (20) également raccordées à la piste conductrice de tension d'alimentation (14) des liaisons électroconductrices (46, 50) qui sont disposées respectivement entre une borne de grille (34, 40) d'un transistor (16, 18) et un raccord (28, 30) du composant de commande (20).

11. Surface de protection disposée entre deux cartes à circuits imprimés, dans le cadre de laquelle
- les cartes à circuits imprimés présentent des circuits de protection selon l'une des revendications précédentes,
- il est monté sur chacune des deux cartes à circuits imprimés
o au moins une piste conductrice de tension d'alimentation,
o au moins un commutateur à semi-conducteurs et
o au moins un composant de commande
- une première des deux cartes à circuits imprimés est montée au-dessus d'une deuxième carte à circuits imprimés et
- la première et la deuxième carte à circuits imprimés sont reliées mécaniquement et/ou électriquement,
et la surface de protection est **caractérisée par** une surface conductrice qui est disposée entre la première et la deuxième carte à circuits imprimés et protège l'une de l'autre la première et la deuxième carte à circuits imprimés, et dans le cadre de laquelle, de préférence,
la surface conductrice possède un potentiel de masse.

12. Système électronique pour faire fonctionner un système de frein de stationnement électromécanique d'un véhicule automobile, comprenant au moins une unité d'entrée (710) pour saisir un souhait du conducteur, lequel souhait est analysé par une unité de commande qui comprend au moins une unité de réglage (731, 732) pour actionner au moins un frein, ladite unité de commande comportant au moins deux composants de commande (721, 722, 723) dont un premier composant de commande (721) est associé à l'unité d'entrée (710) et au moins un deuxième composant de commande (722, 723) est associé à ladite unité de réglage (731, 732), le système électronique comportant au moins un circuit de protection selon la revendication 1 à 10.

13. Système électronique selon la revendication 12, dans le cadre duquel le circuit de protection selon l'une des revendications 1 à 10 est compris dans au moins un des composants de commande (721, 722, 723), et/ou dans le cadre duquel ledit deuxième composant de commande (722, 723) est intégré dans ladite unité de réglage (731, 732) et comprend au moins un circuit de protection selon l'une des revendications 1 à 10.

14. Système électronique pour faire fonctionner un système de frein de stationnement électromécanique d'un véhicule automobile, comprenant au moins une unité d'entrée (710) pour saisir un souhait du conducteur, lequel souhait est analysé par une unité de commande qui commande ladite unité de réglage (732, 732) pour actionner au moins un frein, l'unité de commande comportant au moins deux composants de commande (721, 722, 723) dont un premier composant de commande (721) est associé à l'unité d'entrée (710) et au moins un deuxième composant de commande (722, 723) est associé à ladite unité de réglage (731, 732), le système électronique comportant au moins une surface de protection selon la revendication 11.

15. Système électronique selon la revendication 14, dans le cadre duquel la surface de protection selon la revendication 11 est comprise dans au moins un des composants de commande (721, 722, 723), et/ou dans le cadre duquel ledit deuxième composant de commande (722, 723) est intégré dans ladite unité de réglage (732, 732) et comprend au moins une surface de protection selon la revendication 11.
